# EUROPEAN PATENT APPLICATION

(11) **EP 4 586 179 A1**
(43) Date of publication of application: **16.07.2025**
(21) Application number: 24223758.4
(22) Date of filing: 30.12.2024
(51) Int. Cl.: G06Q 50/06, H02J 3/00

(54) **SIMULATION OF A MICROGRID**

(30) Priority: 12.01.2024 US 202418412171
(71) Applicant: Cummins Power Generation Inc., Minneapolis, MN 55432 (US)
(72) Inventor: Joshi, Rohit, Joshi Pune (IN)
(74) Representative: Cleveland Scott York

(57) **Abstract**

Aspects of this technical solution can include receiving, at a controller device integrated with an electrical device and via a communication interface corresponding to a first simulated route and a second simulated route of an electrical microgrid, a first instruction to simulate an input having a first electrical property via a first route including the electrical device and corresponding to the first simulated route, generating, in response to receiving the first instruction at the controller device, a second instruction to simulate an output having a second electrical property via a second route including the electrical device and corresponding to the second simulated route, and transmitting, from the controller device via the communication interface, the second instruction to simulate the output by the electrical device via the second route.

## Description

### TECHNICAL FIELD

The present implementations relate generally to power systems, including but not limited to simulation of inputs and/or outputs of devices via routes of a microgrid.

### BACKGROUND

Infrastructure for delivering electricity in an electrical distribution system, such as a microgrid, is increasingly expected to be robust enough to withstand external shocks and failures without loss of power delivery capability. Understanding and managing potential failures of power system elements is increasingly critical to maintaining uptime. However, conventional systems cannot effectively assess or predict/simulate interactions between electrical elements of specific deployments.

### SUMMARY

This technical solution is directed at least to a simulation architecture to simulate operation of one or more devices of a microgrid system according of the topology of that specific architecture. For example, the technical solution can include one or more electronic devices including a model corresponding to power delivery devices, and can simulate the power inputs and power outputs of the power delivery devices via a communication interface distinct from the power delivery bus of the microgrid architecture. Via the communication interface, the microgrid architecture can simulate operation or failure of particular power delivery devices of the microgrid network. Thus, a technical solution for simulation of inputs and/or outputs of devices via routes of a microgrid network is provided.

At least one aspect is directed to a method of simulating operation of one or more devices in an electrical microgrid by a communication interface corresponding to a first simulated route and a second simulated route of the electrical microgrid. The method can include receiving, at a controller device via a communication interface, a first instruction to simulate an input via a first route. The controller device can be integrated with an electrical device. The input can have a first electrical property. The first route can include the electrical device and corresponding to a first simulated route of an electrical microgrid. The method can include generating, in response to receiving the first instruction at the controller device, a second instruction to simulate an output via a second route. The output can have a second electrical property. The second route can include the electrical device and can correspond to a second simulated route of the electrical microgrid. The method can include transmitting, from the controller device via the communication interface, the second instruction to simulate the output by the electrical device via the second route.

At least one aspect is directed to a method of simulating operation of one or more devices in an electrical microgrid. The method can include configuring, based on a type of a device coupled with a controller device, the controller device to simulate one or more of input and output of the device, the device configured to transmit electrical power via one or more routes of an electrical microgrid. The method can include transmitting, via a communication interface coupled with the controller device, an instruction to simulate one or more of the input and the output of the device, the instruction indicating an electrical property of one or more of the input and the output of the device via one or more of the routes.

At least one aspect is directed to a non-transitory computer readable medium can include one or more instructions stored thereon and executable by a processor. The processor can generate, by a processor via a communication interface, during simulation in a first mode and in response to receiving a first instruction to simulate an input via a first route, a second instruction to simulate an output via a second route. The communication interface can correspond to a first simulated route and a second simulated route of an electrical microgrid. The first instruction can have a first electrical property. The first route can correspond to the first simulated route and can include an electrical device coupled with the processor. The output can have a second electrical property. The second route can include the electrical device and can correspond to the second simulated route. The processor can transmit, by the processor via the communication interface and during the simulation in the first mode, the second instruction to simulate the output by the electrical device via the second route.

### BRIEF DESCRIPTION OF THE FIGURES

These and other aspects and features of the present implementations are depicted by way of example in the figures discussed herein. Present implementations can be directed to, but are not limited to, examples depicted in the figures discussed herein. Thus, this disclosure is not limited to any figure, or portion thereof, depicted or referenced herein, or any aspect described herein with respect to any figures depicted or referenced herein.
FIG. 1 depicts an example microgrid system, in accordance with present implementations.
FIG. 2 depicts an example object table associated with a system, in accordance with present implementations.
FIG. 3 depicts an example microgrid system in a no-fault simulation state, in accordance with present implementations.
FIG. 4 depicts an example route table associated with a no-fault simulation state, in accordance with present implementations.
FIG. 5 depicts an example microgrid system in a faulted simulation state, in accordance with present implementations.
FIG. 6 depicts an example route table associated with a faulted simulation state, in accordance with present implementations.
FIG. 7 depicts an example simulation device architecture, in accordance with present implementations.
FIG. 8 depicts an example simulation control architecture, in accordance with present implementations.
FIG. 9 depicts an example method of simulation of devices via routes of a microgrid network, in accordance with present implementations.
FIG. 10 depicts an example method of configuration and simulation of devices via routes of a microgrid network, in accordance with present implementations.

### DETAILED DESCRIPTION

Aspects of this technical solution are described herein with reference to the figures, which are illustrative examples of this technical solution. The figures and examples below are not meant to limit the scope of this technical solution to the present implementations or to a single implementation, and other implementations in accordance with present implementations are possible, for example, by way of interchange of some or all of the described or illustrated elements. Where certain elements of the present implementations can be partially or fully implemented using known components, only those portions of such known components that are necessary for an understanding of the present implementations are described, and detailed descriptions of other portions of such known components are omitted to not obscure the present implementations. Terms in the specification and claims are to be ascribed no uncommon or special meaning unless explicitly set forth herein. Further, this technical solution and the present implementations encompass present and future known equivalents to the known components referred to herein by way of description, illustration, or example.

Referring to the figures generally, various embodiments disclosed herein relate to methods, computer-readable storage media, and systems for performing simulations in electrical microgrids. Some embodiments aim to improve existing power system control schemes with systems, apparatuses, and methods structured to sequence and connect, disconnect, and transition sources to load busses for any arbitrary power system topology. Some embodiments control structures for connecting and disconnecting specific load circuits. In general, embodiments discussed herein identify components of a power system as objects within a system architecture. For example, a power system may include source objects (e.g., a power grid connection provided by a utility company, a generator set, a solar array, a battery bank, etc.), bus objects (e.g., source buses, load buses, distribution buses, etc.), transformer objects (e.g., a passive power transformer), switch objects (e.g., automatic transfer switches (ATS), load switches, source switches, circuit breakers, etc.), load objects, load circuits, and controller objects (e.g., source controllers, load bus controllers, switch controllers, etc.). Each object is assigned an individual object identifier and inserted into a system architecture that can be represented with a one-line topology. Routes are then defined between each source and each load defined on the one-line topology to establish potential routes for power transfer from sources to loads. For example, in some system architectures, more than one route may be available to provide power from one source to a given load. Each route is assigned an individual route identifier. Each object is then assigned or allocated to a controller. Typically, an object will be assigned to an adjacent controller. For example, a given physical object representing a given source, load, bus, transformer, or controller is logically assigned or allocated to a physical controller to be managed in the distributed control system. For example, this controller is physically adjacent to or co-located with the given physical object being represented and controlled. For example, a genset controller coupled to and controlling a generator set source object may also be allocated to control a source bus. Once each object has been allocated to a controller, the power system can control operation of the objects using a centralized controller in communication with each individual controller object, or a distributed control scheme. For example, a floating principal control scheme can be used wherein one controller object within the power system is assigned to act as a centralized control for a particular task, but the individual controller object that is acting as the centralized control changes depending on the task required by the power system, or controller loads, resources, or availability. In other embodiments, a fully distributed control scheme is employed wherein all controller objects that perform a particular system function are equals. One characteristic that makes them fully distributed is that each controller determines its own action to take, rather than determining action for others (as in the case of a principal in the floating principal control scheme). In both the floating principal control scheme and the fully distributed control scheme, redundancy is provided in the system because more than one controller object is capable of operating the functions of the power system.

The object-based system architecture allows the design, implementation or commissioning, and operation of the power system to be simplified. Each object is recognized by each controller and is customized with attributes or parameters. For example, each controller can have one or more given objects connected thereto or one or more routes for one or more of the given objects. The ability to build one-line, topology-based systems and control using object-based routes improves the efficiency of design and construction, while providing a more robust control scheme.

This technical solution is directed to simulation of one or more devices of a power system and simulation of transmission of power via one or more routes of the power system according to the particular topology of that power system. The technical solution can include one or more processors configured to simulate power transmitted by the devices according to models corresponding to those devices. For example, a model can correspond to a device having a "genset" type, and can generate simulated power output based on simulated power input to a genset device. The processors can be standalone, or located at or integrated with various devices or control systems co-located with those devices. The processors can be configured to transmit instructions via a communication interface, corresponding to simulated input and output via routes of the power system according to the topology of the power system. Thus, this technical solution can provide at least a technical improvement of on-site simulation of a power system according to the deployed topology of that power system, to provide more accurate and more responsive simulation of the power system. This technical solution can provide at least the technical improvement of applying simulation to test responses of one or more control devices in an unpowered state of the microgrid. For example, an unpowered state of the microgrid can include a state with no power flow or high voltages through one or more routes.

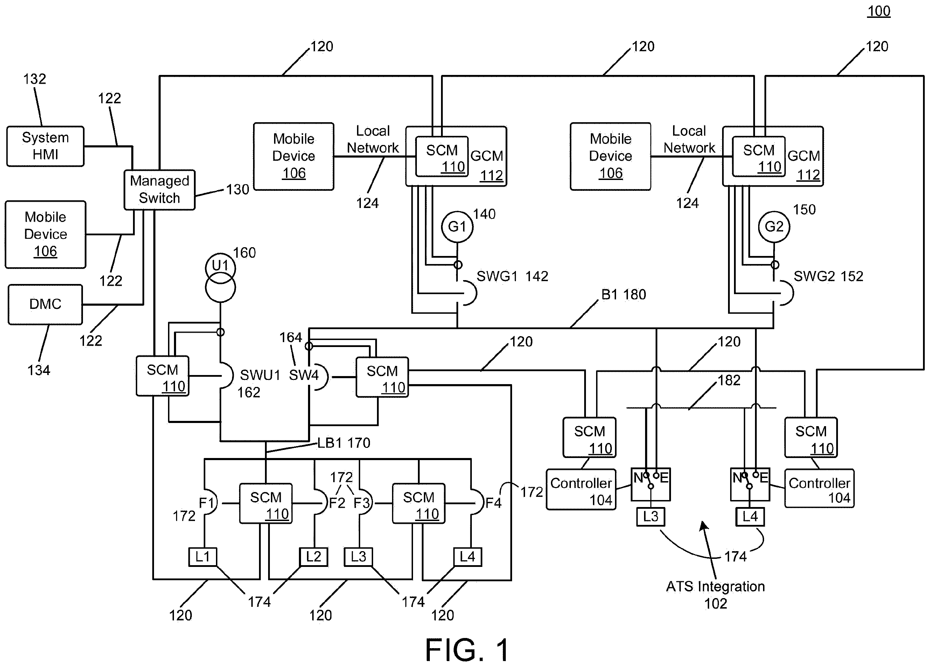

FIG. 1 depicts an example microgrid system, in accordance with present implementations. As illustrated by way of example in FIG. 1, an example microgrid system 100 can include at least an automatic transfer switch (ATS) integration 102, mobile devices 106, a system control module (SCM) 110, a communication line 120, a control communication line 122, a local communication line 124, a managed switch 130, a first genset 140, a first genset switch 142, a second genset 150, a second genset switch 152, a utility 160, a utility switch 162, a system switch 164, a load bus subsystem 170, and system bus 180. For example, the system 100 can correspond to a microgrid of a residence or residential unit, commercial space or commercial area, industrial facility or portion thereof, or any combination thereof.

The ATS integration 102 can activate and deactivate one or more connections of the system 100 with one or more particular sources of power. For example, a source of power can include a power grid serving a particular geographic area, a diesel generator providing power to a particular site, or a battery device providing power to a particular site. The ATS integration 102 can include controllers 104, and an ATS bus 182. The load bus subsystem 170 can couple one or more loads and switches corresponding to the loads of the system 100. The load bus subsystem 170 can include load bus switches 172, and loads 174. The system bus 180 can couple one or more of the devices of the system 100 to transmit power via one or more routes of the system 100. For example, the system bus 180 can couple with one or more of the first genset 140, the first genset switch 142, the second genset 150, the second genset switch 152, the utility switch 162, and the system switch 164. This technical solution is not limited to the configuration of system 100 as illustrated herein by way of example.

The controllers 104 can include one or more processors to collectively or individually activate or deactivate connection of the system 100 with a particular source of power. For example, the controllers 104 can include or be operatively coupled with processors that include logic to switch from a power grid to a diesel or battery source in response to detection of a voltage or current drop satisfying a particular threshold. For example, the controllers 104 can actuate one or more switches of the ATS integration 102 to switch the system 100 from connection with a power grid to connection with a diesel generator, in response to a determination that voltage or current of the power grid satisfies a condition indicating a power outage of the power grid. The ATS bus 182 can route power among one or more objects of the system 100 and a source of power of the system 100.

The mobile devices 106 can include or correspond to any electronic device capable of communication via a network interface and having portability with respect to its physical location. For example, the mobile devices 106 can include, but are not limited to, smartphones, tables, laptop computers, wearable devices, autonomous or semiautonomous vehicles, service tools, or any combination thereof. The mobile devices 106 can be substituted for devices lacking portability. For example, devices lacking portability can include, but are not limited to, desktop computers, workstations, monitors, or any combination thereof. The mobile devices 106 or any substitute can present information related to a state of the system 100 or any component thereof. The mobile devices 106 or any substitute can be configured to transmit information to the system 100 or any component thereof, including, for example, to modify operation of the system 100 or any component thereof.

The SCM 110 can be coupled with one or more devices configured to provide or receive power via the system 100, and can simulate operation of one or more devices coupled with the SCM 110. For example, the SCM 110 can correspond to a microcontroller integrated with a control device or system located at or integrated with an assembly of one or more power devices. For example, power devices can include electrical devices coupled with the system 100 to receive power, transmit power, convert power, conduct power, or any combination thereof. The system 100 can include a plurality of SCM 110 devices, each located at particular assemblies of particular power devices of the system 100. It is noted that SCM 110 devices can also be standalone devices, and are not limited to being associated with an electrical device. For example, an SCM 110 not associated directly with an electrical device can provide additional control processing power for the system 100 or sensing. In some implementations, such an SMC 110 can be provided for use with power monitors or metering devices. The system 100 can include, but is not limited to, the plurality of SCMs 110 illustrated in system 100, by way of example. The SCM 110 can include one or more logical or electronic devices including but not limited to integrated circuits, logic gates, flip flops, gate arrays, programmable gate arrays, and the like. The SCM 110 can be integrated with or in communication with a genset control module (GCM) or other local electrical equipment control 112.

Each SCM 110 can simulate one or more of the power devices connected therewith. The SCMs 110 can simulate one or more power devices based on a power delivery model corresponding to each of the power devices. For example, a first SCM 110 can be coupled with a first device, and can be configured to simulate the first device. Similarly, a second SCM 110 can be coupled with a second device and a third device, and can be configured to simulate the second device and the third device. Each of the SCMs 110 can be configured to simulate the devices with which they are coupled in the microgrid, to provide the technical improvement of an on-site simulation architecture that provides higher accuracy of simulation based on the actual power architecture topology of the system being simulated. One or more of the SCMs 110 can be set to a simulation mode or a live mode. For example, the simulation mode can correspond to a mode in which the SCM 110 simulates the device or devices with which it is connected. For example, the live mode can correspond to a mode in which the SCM 110 operates the device or devices with which it is connected, including power transmission by the device or devices via one or more routes of the system 100.

The GCM 112 can control various aspects of devices coupled with the SCM 110. For example, various ones of the SCMs 110 can be integrated into or with a GCM 112, where the GCM can perform operations corresponding to the devices. For example, the GCM 112 can perform operations or control functions corresponding to devices coupled with the GCM 112. For example, the GCM 112 can include electrical or electronic components to perform system initialization, self-test, shutdown, or fail-safe activation, or any combination thereof. The GCM 112 can include one or more logical or electronic devices including but not limited to integrated circuits, logic gates, flip flops, gate arrays, programmable gate arrays, and the like. One or more electrical, electronic, or like devices, or components associated with the SCM 110 can also be associated with, integrated with, integrable with, replaced by, supplemented by, complemented by, or the like, the GCM 112 or any component thereof. It is noted that SCMs 110 can also be coupled to other local electrical device controls, such as ATS controllers.

The communication line 120 can correspond to a connection via a wired or wireless connection between at least one or more SCMs 110. For example, the communication line 120 can transmit packetized network communication, including but not limited to communication via Ethernet. The control communication line 122 can correspond to a connection via a wired or wireless connection with one or more the human machine interfaces (HMI) or system controllers of the system 100. For example, the control communication line 122 can couple one or more devices to control one or more of devices or controllers of the system 100. For example, the control communication line 122 can obtain or transmit instructions to operate the system 100, including the SCMs 110, in one or more of a simulation mode and a live mode. The local communication line 124 can correspond to a connection via a wired or wireless connection with one or more system controllers of the system 100. For example, the local communication line 124 can correspond to a consumer wireless network including, for example, according to a near-field radio band, Bluetooth, or a wireless Internet band, to allow, for example, local controllers to be associated with the electrical device, or mobile devices 106. The mobile devices 106 can thus obtain communication from one or more of the SCMs 110 with which they are coupled, via the local communication line 124. The mobile devices 106 can present a user interface indicating the simulation mode corresponding to one or more of the SCMs 110 with which the user interface is linked via the local communication line 124, and the system 100.

The managed switch 110 can transmit information across the system 100 or one or more components thereof. For example, in some implementations, the managed switch 130 is a communication hub that forwards packets from the Digital Master Controller (DMC), Mobile Device 106, or the system HMI 132. For example, the managed switch can receive communication packets from the system controller or the system HMI 132. Additionally or alternatively, the managed switch 130 can transmit communication packets by the communication line 120 responsive to instructions of a local system controller or the system HMI 132. For example, the managed switch 130 can operate as a network gateway, network hub, firewall, or bridge.

The system HMI 132 can include a user interface to receive input from a user to control the system 100 or an aspect thereof. For example, the system HMI 132 can include a display device with a touch interface. The display device can display at least one or more aspects of the system 100 or the SCMs 110, and can include an electronic display. An electronic display can include, for example, a liquid crystal display (LCD), a light-emitting diode (LED) display, an organic light-emitting diode (OLED) display, or the like. The display device can receive, for example, capacitive or resistive touch input. The system HMI 132 can present a user interface corresponding to or including information corresponding to the user interface of the mobile devices 106. The DMC 134 can transmit instructions compatible with the SCM 110 based on instructions received via the system HMI 132. For example, the DMC 134 can include a command translation processor to convert one or more commands from a format compatible with the system HMI 132 to a format compatible with the SCMs 110 or the communication line 120. The DMC 134, for example, can convert instructions to an embedded format compatible with a microcontroller architecture of the SCM 110. The HMI 132 and the DMC 134 are not limited to the arrangement illustrated by way of example in system 100. The system 100 can optionally include the DMC 134 in a local connection to the communication line 120.

For example, the system HMI 132 can cause one or more of the SCMs 110 to operate in a simulation mode, or to switch between a simulation mode and a live mode, in response to a user selection of a simulation mode or a live mode via a user interface of the system HMI 132. For example, the system HMI 132 can instruct one or more of the SCMs 110 to operation in a fault state or a no-fault state of the simulation mode, and can instruct particular SCMs 110 to operate in fault states or no-fault states in accordance with a simulation profile. For example, a simulation profile can correspond to a simulation of the system 100 in response to failure of particular portions of the system 100, or operation in the absence of any failure of the system 100. While selection of simulation mode or live mode via the user interface of the system HMI 132 is discussed by way of example herein, this disclosure is not limited to selection of any mode via the system HMI 132.

The first genset 140 can correspond to a device configured to transmit power via one or more routes of the system 100. For example, the first genset 140 can be coupled with a first SCM 110 among the SCMs 110, and can be coupled with a first GCM 112 among the GCMs 112. The first genset 140 can transmit an identifier indicating a type or operating characteristic, or any combination thereof, to the first SCM 110, to configure the first SCM 110 to simulate the first genset 140. The first GCM 112 can transmit the identifier indicating the type or operating characteristic of the first genset 140, or any combination thereof, to the first SCM 110, to configure the first SCM 110 to simulate the first genset 140. The system HMI 132 can transmit the identifier indicating the type or operating characteristic of the first genset 140, or any combination thereof, to the first SCM 110, to configure the first SCM 110 to simulate the first genset 140. The first genset switch 142 can correspond to a switch configured to control transmission of power via one or more routes of the system 100. For example, the first genset switch 142 can be coupled with a first SCM 110 among the SCMs 110, and can be coupled with a first GCM 112 among the GCMs 112.

The first genset switch 142 can transmit an identifier indicating a type or operating characteristic, or any combination thereof, to the first SCM 110, to configure the first SCM 110 to simulate the first genset switch 142. The first GCM 112 can transmit the identifier indicating the type or operating characteristic of the first genset switch 142, or any combination thereof, to the first SCM 110, to configure the first SCM 110 to simulate the first genset switch 142. The system HMI 132 can transmit the identifier indicating the type or operating characteristic of the first genset switch 142, or any combination thereof, to the first SCM 110, to configure the first SCM 110 to simulate the first genset switch 142. Thus, the first SCM 110 of the SCMs 110 can be configured to simulate one or both of the first genset 140 and the first genset switch 142.

The second genset 150 can correspond to a device configured to transmit power via one or more routes of the system 100, distinct from the first genset 140. For example, the second genset 150 can be coupled with a second SCM 110 among the SCMs 110, and can be coupled with a second GCM 112 among the GCMs 112. The second genset 150 can transmit an identifier indicating a type or operating characteristic, or any combination thereof, to the second SCM 110, to configure the second SCM 110 to simulate the second genset 150. The second GCM 112 can transmit the identifier indicating the type or operating characteristic of the first genset 140, or any combination thereof, to the second SCM 110, to configure the second SCM 110 to simulate the second genset 150. The system HMI 132 can transmit the identifier indicating the type or operating characteristic of the second genset 150, or any combination thereof, to the second SCM 110, to configure the second SCM 110 to simulate the second genset 150.

The second genset switch 152 can correspond to a switch configured to control transmission of power via one or more routes of the system 100. For example, the second genset switch 152 can be coupled with a second SCM 110 among the SCMs 110, and can be coupled with a second GCM 112 among the GCMs 112. The second genset switch 152 can transmit an identifier indicating a type or operating characteristic, or any combination thereof, to the second SCM 110, to configure the second SCM 110 to simulate the second genset switch 152. The second GCM 112 can transmit the identifier indicating the type or operating characteristic of the second genset switch 152, or any combination thereof, to the second SCM 110, to configure the SCM 110 to simulate the second genset switch 152. The system HMI 132 can transmit the identifier indicating the type or operating characteristic of the second genset switch 152, or any combination thereof, to the second SCM 110, to configure the second SCM 110 to simulate the second genset switch 152. Thus, the second SCM 110 of the SCMs 110 can be configured to simulate one or both of the second genset 150 and the second genset switch 152.

The utility 160 can correspond to a device configured to transmit or transform power via one or more routes of the system 100, distinct from the first genset 140 and the second genset 150. For example, the utility 160 can be coupled with a third SCM 110 among the SCMs 110. The utility 160 can transmit an identifier indicating a type or operating characteristic, or any combination thereof, to the third SCM 110, to configure the third SCM 110 to simulate the utility 160. The system HMI 132 can transmit the identifier indicating the type or operating characteristic of the utility 160, or any combination thereof, to the third SCM 110, to configure the third SCM 110 to simulate the utility 160. The utility switch 162 can correspond to a switch configured to control transmission of power via one or more routes of the system 100. For example, the utility switch 162 can be coupled with a third SCM 110 among the SCMs 110. The utility switch 162 can transmit an identifier indicating a type or operating characteristic, or any combination thereof, to the third SCM 110, to configure the third SCM 110 to simulate the utility switch 162. The system HMI 132 can transmit the identifier indicating the type or operating characteristic of the utility switch 162, or any combination thereof, to the third SCM 110, to configure the third SCM 110 to simulate the utility switch 162. Thus, the third SCM 110 of the SCMs 110 can be configured to simulate one or both of the utility 160 and the utility switch 162.

The system switch 164 can correspond to a switch configured to control transmission of power via one or more routes of the system 100. The system switch 164 can couple multiple busses of the system 100, including the load bus of the load bus subsystem 170 and the system bus 180. For example, the system switch 164 can be coupled with a fourth SCM 110 among the SCMs 110. The system switch 164 can transmit an identifier indicating a type or operating characteristic, or any combination thereof, to the fourth SCM 110, to configure the fourth SCM 110 to simulate the system switch 164. The system HMI 132 can transmit the identifier indicating the type or operating characteristic of the system switch 164, or any combination thereof, to the fourth SCM 110, to configure the fourth SCM 110 to simulate the system switch 164. Thus, the fourth SCM 110 of the SCMs 110 can be configured to simulate the system switch 164. For example, along with the system switch 164, the corresponding SCM 110 can also monitors the system bus 180. Thus, the SCM 110 can be configured to simulate the system bus 180 and the system switch 164.

The load bus switches 172 can control transmission of power via one or more routes of the system 100 corresponding to the load bus subsystem 170. For example, a first pair of the load bus switches 172 can be coupled with a fifth SCM 110 among the SCMs 110. The first pair of the load bus switches 172 can transmit an identifier indicating a type or operating characteristic, or any combination thereof, to the fifth SCM 110, to configure the fifth SCM 110 to simulate the each of the first pair of the load bus switches 172. The system HMI 132 can transmit the identifier indicating the type or operating characteristic of the first pair of the load bus switches 172, or any combination thereof, to the fifth SCM 110, to configure the fifth SCM 110 to simulate each of the first pair of the load bus switches 172. Thus, the fifth SCM 110 of the SCMs 110 can be configured to simulate each of the first pair of the load bus switches 172.

For example, a second pair of the load bus switches 172 can be coupled with a sixth SCM 110 among the SCMs 110. The second pair of the load bus switches 172 can transmit an identifier indicating a type or operating characteristic, or any combination thereof, to the sixth SCM 110, to configure the sixth SCM 110 to simulate the each of the first second of the load bus switches 172. The system HMI 132 can transmit the identifier indicating the type or operating characteristic of the second pair of the load bus switches 172, or any combination thereof, to the sixth SCM 110, to configure the sixth SCM 110 to simulate each of the second pair of the load bus switches 172. Thus, the sixth SCM 110 of the SCMs 110 can be configured to simulate each of the second pair of the load bus switches 172. The loads 174 can correspond to devices that consume power of the system 100. For example, the loads 174 can correspond to any power-consuming device coupled with or that can be coupled with the microgrid.

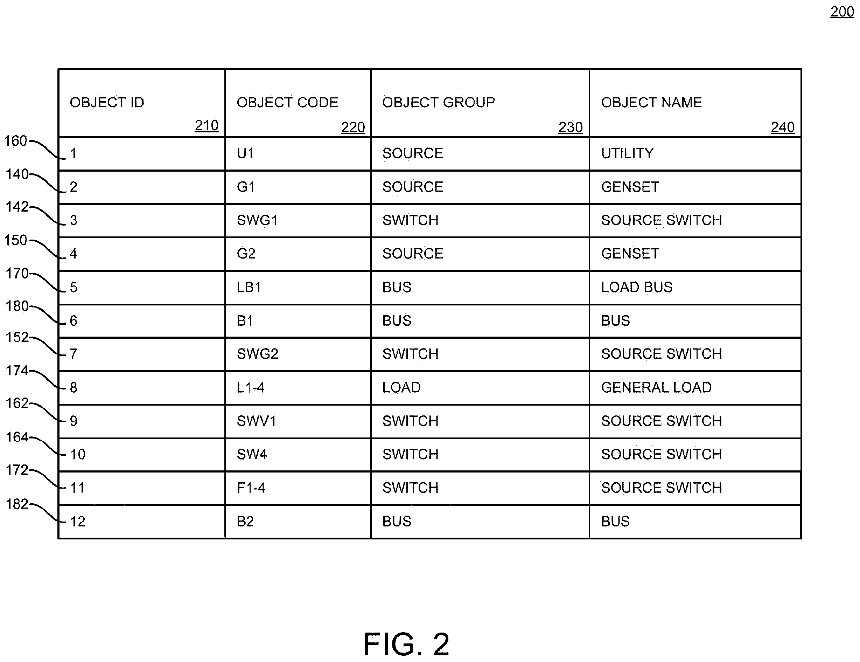

FIG. 2 depicts an example object table associated with a system, in accordance with present implementations. As illustrated by way of example in FIG. 2, an example object table associated with a system 200 can include at least an object ID index 210, an object code index 220, an object group index 230, and an object name index 240.

Power systems generally include five object types: source objects, bus objects, switch objects, load objects, and transformer objects. For example, the system 100 or a system in accordance with present implementations can include a transformer object. For example, each component is identified with an object ID in the object ID index 210, an object name in the object name index 240, an object code in the object code index 220, and an object group in the object group index 230. The object ID and object name are used by the controllers (e.g., genset controller and switch controller) to identify components. The object type defines what parameters of the object can be simulated.

Each object type has its responsibilities (functions) in the operation of the system 100. Each object type also has attributes that define its identity and ratings. Note that most objects, but not all, are machines in the system 100. For example, B1, B2 and LB1 are bus object types and are important in the operation and coordination of the system 100, but they are not technically machines. The system 100 itself may also be considered as an object, as well as a controller (e.g., the genset controller and the switch controller). An object type becomes a container for functionality that the object type owns.

For example, each instance of an object type can include a number of functions, parameters, or attributes that can be customized to represent the operation of the individual object within a power system (e.g., the system 100). In other words, a power system is abstracted to be composed of various objects having corresponding object types including but not limited to, one or more of sources, busses, switches, loads, transformers, and additionally controllers, with the system itself. According to embodiments disclosed herein, power systems can be arranged as a collection of object instances; one instance for each occurrence of that type of object. Each object type is a container for a superset of system control functions tied to that object type. The set of functions contained by an object type are always the same implementation (e.g., software code) regardless of where the object instance is in the power system. The behavior of an individual object instance is modified only through configuration setting changes, not through new software code (e.g., 'C' code). The power system can thus be simulated via a distributed arrangement of SCMs 110 according to the topology and the connections of the objects via the busses of the particular system.

Object instances get distributed to the controllers around the system typically based on what the controllers are physically connected to. This enables functional abstraction from any particular controller implementation or specific installation controller topology. That is, the objects and functions are largely decoupled from the controller(s) they will five/run on. For example, a genset controller (e.g., the GCM 112) may control the functions of an associated genset (e.g., the first genset 140) by controlling fueling, aftertreatment, or the like. The genset controller may also control functions of other objects, and other controllers may impact the operation of the genset controller. Each controller is capable of running multiple instances of the different object types. The objects and their functions all communicate with each other via a common global dataspace. A system-wide global data space can be created by a networking technology and protocol such as DDS on Ethernet. Thus, the functions in each object instance will act in concert with the other object types to accomplish the system control and sequencing needs to operate the power system. For example, an object under simulation can simulate its basic defined functions and can act in concert with other objects under simulation to collectively accomplish system simulation in a distributed manner across multiple SCMS 110 configured to simulate corresponding objects.

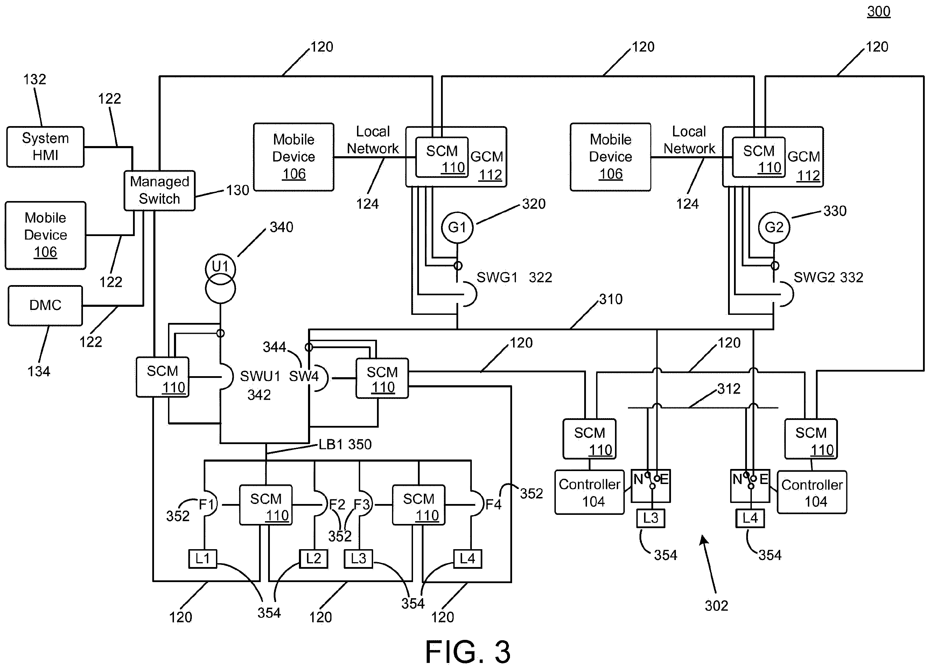

FIG. 3 depicts an example microgrid system in a no-fault simulation state, in accordance with present implementations. As illustrated by way of example in FIG. 3, an example microgrid system in a no-fault simulation state 300 can include at least simulated system bus 310, simulated ATS bus 312, a simulated first genset 320, a simulated first genset switch 322, a simulated second genset 330, a simulated second genset switch 332, a simulated utility 340, a simulated utility switch 342, a simulated system switch 344, and simulated loads 354. For example, in state 300, the SMCs 110 can operate in a simulation mode in a no-fault state, to indicate that the system 100 in state 300 is simulating the system 100 in a no-fault state.

The simulated system bus 310 can correspond to a simulation of the system bus 180 via the communication line 120. For example, communication line 120 can be used for both control data exchange and simulation data exchange. The physical bus corresponding to the simulated system bus 310, the system bus 180, can be in a deactivated or power-off state. For example, in state 300, the SMCs 110 corresponding to the devices coupled with the system bus 180 can operate in a simulation mode in a no-fault state, to indicate that the system 300 is simulating the system bus 180 in a no-fault state. Thus, the simulated system bus 310 can simulate operation of the system bus 180 while the system bus 180 is not operational. The simulated ATS bus 312 can correspond to a simulation of the ATS bus 182 via the communication line 120. For example, in state 300, the SMCs 110 corresponding to the controllers 104 of the ATS integration 102 can operate in a simulation mode in a no-fault state, to indicate that the system 300 is simulating the simulated ATS bus 312 in a no-fault state. Thus, the simulated system bus 310 can simulate operation of the system bus 180 while the system bus 180 is not operational.

The simulated first genset 320 can correspond to a simulation by the first SCM 110 of the first genset 140 in a no-fault state. For example, the simulated first genset 320 can receive instructions via the communication line 120 corresponding to one or more of simulated input and output indicating electrical power via the system bus 180. The first SCM 110 can obtain and execute a model corresponding to the type of the first genset 140 or a characteristic of the first genset 140, to simulate the first genset 140 according to the simulated first genset 320. The simulated first genset switch 322 can correspond to a simulation by the first SCM 110 of the first genset switch 142 in a no-fault state. For example, the simulated first genset switch 322 can receive instructions via the communication line 120 corresponding to one or more of simulated input and output indicating electrical power via the system bus 180. The first SCM 110 can obtain and execute a model corresponding to the type of the first genset switch 142 or a characteristic of the first genset switch 142, to simulate the first genset switch 142 according to the simulated first genset switch 322.

The simulated second genset 330 can correspond to a simulation by the second SCM 110 of the second genset 150 in a no-fault state. For example, the simulated second genset 330 can receive instructions via the communication line 120 corresponding to one or more of simulated input and output indicating electrical power via the system bus 180. The second SCM 110 can obtain and execute a model corresponding to the type of the second genset 150 or a characteristic of the second genset 150, to simulate the second genset 150 according to the simulated second genset 330. The simulated second genset switch 332 can correspond to a simulation by the second SCM 110 of the first genset switch 142 in a no-fault state. For example, the simulated first genset switch 322 can receive instructions via the communication line 120 corresponding to one or more of simulated input and output indicating electrical power via the system bus 180. The second SCM 110 can obtain and execute a model corresponding to the type of the second genset switch 152 or a characteristic of the second genset switch 152, to simulate the second genset switch 152 according to the simulated second genset switch 322.

The simulated utility 340 can correspond to a simulation by the third SCM 110 of the utility 160 in a no-fault state. For example, the simulated utility 340 can receive instructions via the communication line 120 corresponding to one or more of simulated input and output indicating electrical power via the system bus 180. The third SCM 110 can obtain and execute a model corresponding to the type of the utility 160 or a characteristic of utility 160, to simulate the utility 160 according to the simulated utility 340. The simulated utility switch 342 can correspond to a simulation by the third SCM 110 of the utility switch 162 in a no-fault state. For example, the simulated utility switch 342 can receive instructions via the communication line 120 corresponding to one or more of simulated input and output indicating electrical power via the system bus 180. The third SCM 110 can obtain and execute a model corresponding to the type of the utility switch 162 or a characteristic of the utility switch 162, to simulate the utility switch 162 according to the simulated utility switch 342. The simulated system switch 344 can correspond to a simulation by the fourth SCM 110 of the system switch 164 in a no-fault state. For example, the simulated system switch 344 can receive instructions via the communication line 120 corresponding to one or more of simulated input and output indicating electrical power via the system bus 180. The fourth SCM 110 can obtain and execute a model corresponding to the type of the system switch 344 or a characteristic of the system switch 344, to simulate the system switch 344 according to the simulated system switch 344. The simulated loads 354 can correspond to the loads 174 of the ATS integration in a no-fault state. The SCMs 110 of the ATS integration 102 can simulate the one or both of the power sources coupled with the ATS integration 102 as operational.

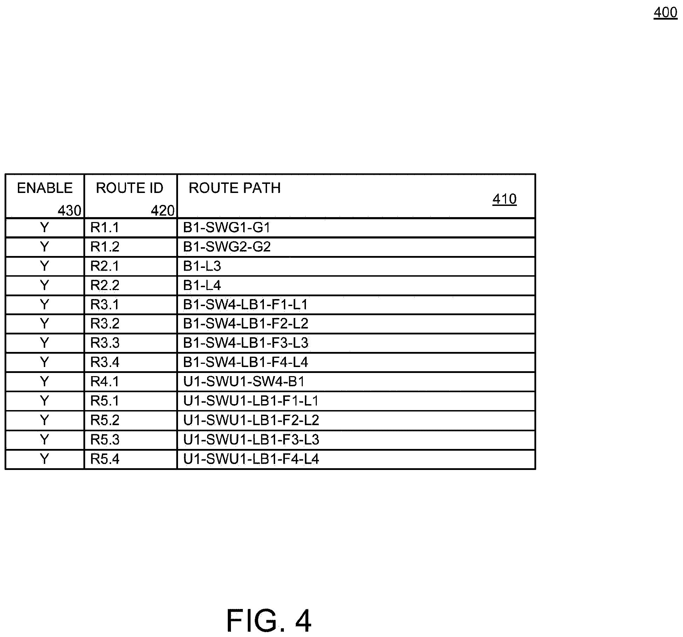

FIG. 4 depicts an example route table associated with a no-fault simulation state, in accordance with present implementations. As illustrated by way of example in FIG. 4, an example route table associated with a no-fault simulation state 400 can include at least a route path index 410, a route ID index 420, and a route enable index 430.

The route path index 410 can indicate a plurality of routes corresponding to the system 100 and the system 300. Each route of a route path index can correspond to a physical route between one or more devices of the system 100, and a corresponding simulated route between one or more SCMs 110 of the system 300. For example, the route path index 410 can include a route B1-SWG1-G1 including the system bus 180, the first genset switch 142, and the first genset 140. For example, the route path index 410 can include a route B1-SWG2-G2 including the system bus 180, the second genset switch 152, and the second genset 150. For example, the route path index 410 can include a route B1-L3 including the system bus 180 and a first load 174 of the ATS integration. For example, the route path index 410 can include a route B 1-L4 including the system bus 180 and a second load 174 of the ATS integration. For example, the route path index 410 can include routes B1-SW4-LB1-F1-L1, B1-SW4-LB1-F2-L2, B1-SW4-LB1-F3-L3, and B1-SW4-LB1-F4-L4. Each of these routes can include the bus of the load bus subsystem 170, and corresponding ones of the load switches 172 and the loads 174 of the load bus subsystem 170. For example, the route path index 410 can include a route U1-SWU1-SW4-B1 including the utility 160, the utility switch 162, the system switch 164, and the system bus 180. For example, the route path index 410 can include routes U1-SWU1-LB1-F1-L1, U1-SWU1-LB1-F2-L2, U1-SWU1-LB1-F3-L3, and U1-SWU1-LB1-F4-L4. Each of these routes can include the utility 160, the utility switch 162, the bus of the load bus subsystem 170, and corresponding ones of the load switches 172 and the loads 174 of the load bus subsystem 170. The SCMs 110 of the system 300 can simulate one or more of the routes of the route path index 410 via the communication line 120.

The route ID index 420 can indicate a route identifier corresponding ton one or more routes of the route path index. For example, the route ID index 420 can indicate a particular identifier for each of the routes of the route path index 410, based on a route category and a route number. A route category can precede a period "." of a route identifier and can be based on a common portion or end of a route relative to one or more other routes. For example, a route number can distinctly identify particular routes sharing a route category. The route enable index 430 can indicate whether a route corresponding to a particular simulation is set to operate or is operating in a no-fault state or a faulted state, and can correspond to the simulation architecture of the no-fault simulation state 300. For example, the route enable index 430 can indicate that all route paths of the route path index 410 are set to be simulated or are being simulated in a no-fault state.

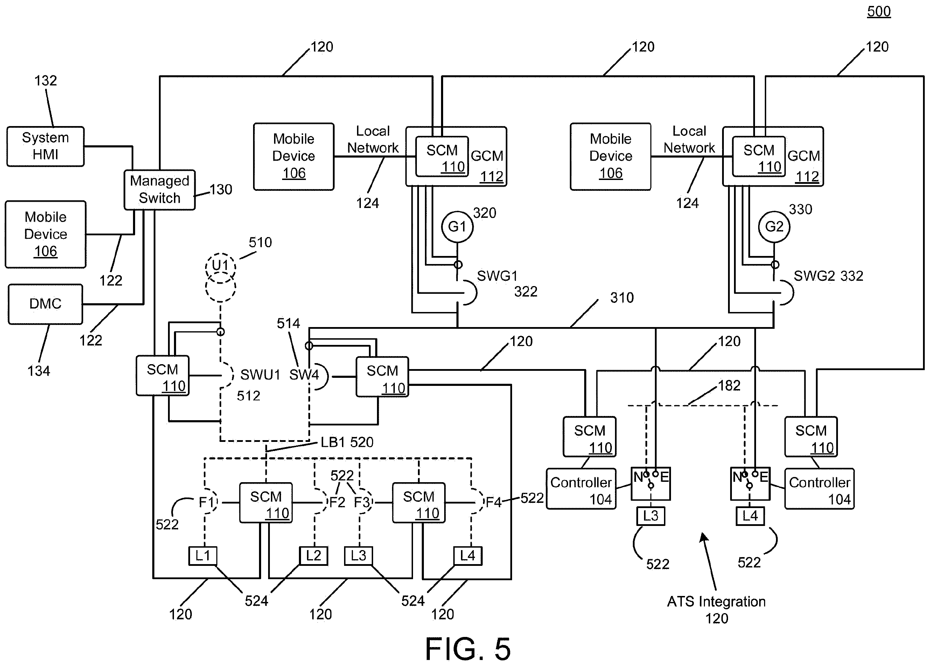

FIG. 5 depicts an example microgrid system in a faulted simulation state, in accordance with present implementations. As illustrated by way of example in FIG. 5, an example microgrid system in a faulted simulation state 500 can include at least a simulated faulted utility 510, a simulated faulted utility switch 512, a simulated faulted system switch 514, and a simulated faulted load bus subsystem 520.

The simulated faulted utility 510 can correspond in structure to the utility 160. The SCM 110 corresponding to the simulated faulted utility 510 can be configured to simulate the utility 160 in a fault state according to the simulated faulted utility 510. For example, the simulated faulted utility 510 can provide no simulated output in response to simulated input, or produce simulated output distinct from simulated output of the simulated utility 340. The simulated faulted utility switch 512 can correspond in structure to the utility switch 162. The SCM 110 corresponding to the simulated faulted utility switch 512 can be configured to simulate the utility switch 162 in a fault state according to the simulated faulted utility switch 512. For example, the simulated faulted utility switch 512 can provide no simulated output in response to simulated input, or produce simulated output distinct from simulated output of the simulated utility switch 342.

The simulated faulted system switch 514 can correspond in structure to the system switch 164. The SCM 110 corresponding to the simulated faulted system switch 514 can be configured to simulate the system switch 164 in a fault state according to the simulated faulted system switch 514. For example, the simulated faulted system switch 514 can provide no simulated output in response to simulated input, or produce simulated output distinct from simulated output of the simulated system switch 344.

The simulated faulted load bus subsystem 520 can correspond in structure to the load bus subsystem 170. The SCM 110 corresponding to the simulated faulted load bus subsystem 520 can be configured to simulate the load bus subsystem 520 in a fault state according to the simulated faulted load bus subsystem 520. For example, the simulated faulted load bus subsystem 520 can provide no simulated output in response to simulated input, or produce simulated output distinct from simulated output of the simulated load bus subsystem 350. The simulated faulted load bus subsystem 520 can include simulated faulted load bus switches 522, and simulated faulted loads 524. The simulated faulted load bus switches 522 can correspond in structure to the load bus switches 172 of the load bus subsystem 170. The SCMs 110 corresponding to the simulated faulted load bus switches 522 can be configured to simulate the load bus switches 172 of the load bus subsystem 170 in a fault state according to the simulated faulted load bus switches 522. For example, the simulated faulted load bus switches 522 can provide no simulated output in response to simulated input, or produce simulated output distinct from simulated output of the simulated load bus switches 352. The simulated faulted loads 524 can correspond in structure to the simulated loads 354. The SCMs 110 corresponding to the simulated faulted load bus switches 522 can be configured to simulate the load bus switches 172 of the load bus subsystem 170 in a fault state according to the simulated faulted loads 524. For example, the simulated faulted loads 524 can provide no simulated output in response to simulated input, or produce simulated output distinct from simulated output of the simulated loads 354.

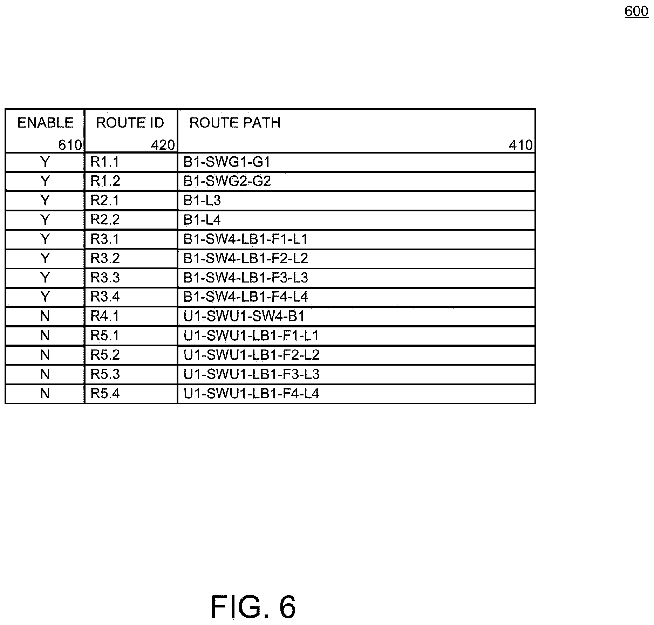

FIG. 6 depicts an example route table associated with a faulted simulation state, in accordance with present implementations. As illustrated by way of example in FIG. 6, an example route table associated with a faulted simulation state 600 can include at least a route enable index 610. The route enable index 610 can indicate whether a route corresponding to a particular simulation is set to operate or is operating in a no-fault state or a faulted state, and can correspond to the simulation architecture of the faulted simulation state 500. For example, the route enable index 610 can indicate that a subset of all route paths of the route path index 410 having a flag corresponding to "Y" are set to be simulated or are being simulated in a no-fault state. For example, the route enable index 610 can indicate that a subset of all route paths of the route path index 410 having a flag corresponding to "N" are set to be simulated or are being simulated in a faulted state, including but not limited to faulted operation of the simulated faulted utility 510, a simulated faulted utility switch 512, a simulated faulted system switch 514, and a simulated faulted load bus subsystem 520.

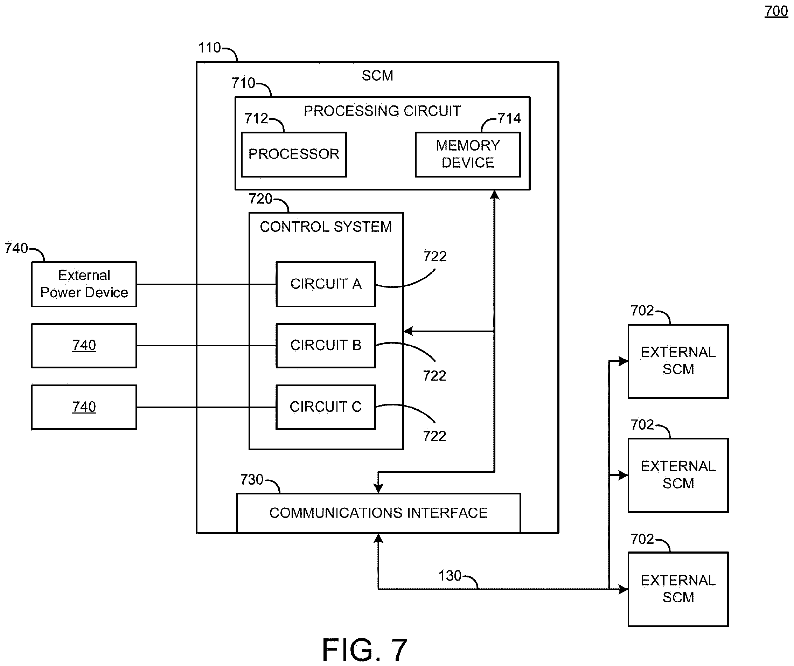

FIG. 7 depicts an example simulation device architecture, in accordance with present implementations. As illustrated by way of example in FIG. 7, an example simulation device architecture 700 can include at least an external SCM 702, a processing circuit 710, a control system 720, a communications interface 730, and an external power device 740. Any or all of the SCMs 110 can have one or more of structure and operation corresponding to the simulation device architecture 700. Any of the SCMs 110 can be coupled with one another, and any SCM 110 distinct from the SCM 110 depicted in FIG. 7 can correspond to the external SCMs 702. Generally, the simulation device architecture 700 can be structured to control operation of an associated object and to act within the larger power routing control scheme of at least systems 100, 300 and 500.

The processing circuit 710 can include one or more logical or electronic devices including but not limited to integrated circuits, logic gates, flip flops, gate arrays, programmable gate arrays, and the like. The processing circuit 710 can include a processor 712, and a memory device 714.

The control system 720 can include one or more logical or electronic devices including but not limited to integrated circuits, logic gates, flip flops, gate arrays, programmable gate arrays, and the like. One or more electrical, electronic, or like devices, or components associated with the control system 720 can also be associated with, integrated with, integrable with, replaced by, supplemented by, complemented by, or the like, the processing circuit 710 or any component thereof. The control system 720 can include circuits 722.

The circuits 722 can include one or more circuits, including but not limited to example circuits A, B and C. In one configuration, the circuit A of the circuits 722, the circuit B of the circuits 722, and the circuit C of the circuits 722 are embodied as machine or computer-readable media that is executable by a processor, such as processor 712. As described herein and amongst other uses, the machine-readable media facilitates performance of certain operations to enable reception and transmission of data. For example, the machine-readable media may provide an instruction (e.g., command, etc.) to, e.g., acquire data. In this regard, the machine-readable media may include programmable logic that defines the frequency of acquisition of the data (or, transmission of the data). The computer readable media may include code, which may be written in any programming language including, but not limited to, Java or the like and any conventional procedural programming languages, such as the "C" programming language or similar programming languages. The computer readable program code may be executed on one processor or multiple remote processors. In the latter scenario, the remote processors may be connected to each other through any type of network (e.g., CAN bus, etc.).

In another configuration, the circuit A of the circuits 722, the circuit B of the circuits 722, and the circuit C of the circuits 722 are embodied as hardware units, such as electronic control units. As such, the circuit A of the circuits 722, the circuit B of the circuits 722, and the circuit C of the circuits 722 may be embodied as one or more circuitry components including, but not limited to, processing circuitry, network interfaces, peripheral devices, input devices, output devices, sensors, etc. In some embodiments, the circuit A of the circuits 722, the circuit B of the circuits 722, and the circuit C of the circuits 722 may take the form of one or more analog circuits, electronic circuits (e.g., integrated circuits (IC), discrete circuits, system on a chip (SOCs) circuits, microcontrollers, etc.), telecommunication circuits, hybrid circuits, and any other type of "circuit." In this regard, the circuit A of the circuits 722, the circuit B of the circuits 722, and the circuit C of the circuits 722 may include any type of component for accomplishing or facilitating achievement of the operations described herein. For example, a circuit as described herein may include one or more transistors, logic gates (e.g., NAND, AND, NOR, OR, XOR, NOT, XNOR, etc.), resistors, multiplexers, registers, capacitors, inductors, diodes, wiring, and so on). The circuit A of the circuits 722, the circuit B of the circuits 722, and the circuit C of the circuits 722 may also include programmable hardware devices such as field programmable gate arrays, programmable array logic, programmable logic devices or the like. The circuit A of the circuits 722, the circuit B of the circuits 722, and the circuit C of the circuits 722 may include one or more memory devices for storing instructions that are executable by the processor(s) of the circuit A of the circuits 722, the circuit B of the circuits 722, and the circuit C of the circuits 722. The one or more memory devices and processor(s) may have the same definition as provided below with respect to the memory device 714 and processor 712. In some hardware unit configurations, the circuit A of the circuits 722, the circuit B of the circuits 722, and the circuit C of the circuits 722 may be geographically dispersed throughout separate locations in the power system. Alternatively and as shown, the circuit A of the circuits 722, the circuit B of the circuits 722, and the circuit C of the circuits 722 may be embodied in or within a single unit/housing, which is shown as the control system 720.

In the example shown, the control system 720includes the processing circuit 512 having the processor 712 and the memory device 714. The processing circuit 512 may be structured or configured to execute or implement the instructions, commands, and/or control processes described herein with respect to circuit A of the circuits 722, the circuit B of the circuits 722, and the circuit C of the circuits 722. The depicted configuration represents the circuit A of the circuits 722, the circuit B of the circuits 722, and the circuit C of the circuits 722 as machine or computer-readable media. However, as mentioned above, this illustration is not meant to be limiting as the present disclosure contemplates other embodiments where the circuit A of the circuits 722, the circuit B of the circuits 722, and the circuit C of the circuits 722, or at least one circuit of the circuit A of the circuits 722, the circuit B of the circuits 722, and the circuit C of the circuits 722, is configured as a hardware unit. All such combinations and variations are intended to fall within the scope of the present disclosure.

The hardware and data processing components used to implement the various processes, operations, illustrative logics, logical blocks, modules and circuits described in connection with the embodiments disclosed herein (e.g., the processor 712) may be implemented or performed with a general purpose single- or multi-chip processor, a digital signal processor (DSP), an application specific integrated circuit (ASIC), a field programmable gate array (FPGA), or other programmable logic device, discrete gate or transistor logic, discrete hardware components, or any combination thereof designed to perform the functions described herein. A general-purpose processor may be a microprocessor, or, any conventional processor, or state machine. A processor also may be implemented as a combination of computing devices, such as a combination of a DSP and a microprocessor, a plurality of microprocessors, one or more microprocessors in conjunction with a DSP core, or any other such configuration. In some embodiments, the one or more processors may be shared by multiple circuits (e.g., circuit A of the circuits 722, the circuit B of the circuits 722, and the circuit C of the circuits 722 may comprise or otherwise share the same processor which, in some example embodiments, may execute instructions stored, or otherwise accessed, via different areas of memory). Alternatively or additionally, the one or more processors may be structured to perform or otherwise execute certain operations independent of one or more co-processors. In other example embodiments, two or more processors may be coupled via a bus to enable independent, parallel, pipelined, or multi-threaded instruction execution. All such variations are intended to fall within the scope of the present disclosure.

The memory device 714 (e.g., memory, memory unit, storage device) may include one or more devices (e.g., RAM, ROM, Flash memory, hard disk storage) for storing data and/or computer code for completing or facilitating the various processes, layers and modules described in the present disclosure. The memory device 714 may be communicably connected to the processor 712 to provide computer code or instructions to the processor 712 for executing at least some of the processes described herein. Moreover, the memory device 714 may be or include tangible, non-transient volatile memory or non-volatile memory. Accordingly, the memory device 714 may include database components, object code components, script components, or any other type of information structure for supporting the various activities and information structures described herein.

For example, each of the circuit A of the circuits 722, the circuit B of the circuits 722, and the circuit C of the circuits 722 can activate, deactivate, and operate power routing control and communicate with the external SCMs 702 via the communication interface 730 to activate/deactivate routes and complete the other actions according to a simulation. For example, each of the circuit A of the circuits 722, the circuit B of the circuits 722, and the circuit C of the circuits 722 can activate, deactivate, and operate power routing control and communicate with the external power devices 740 to activate/deactivate routes and complete the other actions according to power delivery operation via one or more of the busses of the system 100. The external power devices 740 can correspond to one or more of the devices of system 100 and the devices indicated in tables 400 and 600.

For example, the activities and functionalities of the circuit A of the circuits 722, the circuit B of the circuits 722, and the circuit C of the circuits 722 may be combined in multiple circuits or as a single circuit. Additional circuits with additional functionality may also be included. As mentioned above and in one configuration, the "circuits" may be implemented in machine-readable medium for execution by various types of processors, such as the processor 712. An identified circuit of executable code may, for instance, comprise one or more physical or logical blocks of computer instructions, which may, for instance, be organized as an object, procedure, or function. Nevertheless, the executables of an identified circuit need not be physically located together, but may comprise disparate instructions stored in different locations which, when joined logically together, comprise the circuit and achieve the stated purpose for the circuit. Indeed, a circuit of computer readable program code may be a single instruction, or many instructions, and may even be distributed over several different code segments, among different programs, and across several memory devices. Similarly, operational data may be identified and illustrated herein within circuits, and may be embodied in any suitable form and organized within any suitable type of data structure. The operational data may be collected as a single data set, or may be distributed over different locations including over different storage devices, and may exist, at least partially, merely as electronic signals on a system or network.

While the term "processor" is briefly defined above, the term "processor" and "processing circuit" are meant to be broadly interpreted. In this regard and as mentioned above, the "processor" may be implemented as one or more general-purpose processors, application specific integrated circuits (ASICs), field programmable gate arrays (FPGAs), digital signal processors (DSPs), or other suitable electronic data processing components structured to execute instructions provided by memory. The one or more processors may take the form of a single core processor, multi-core processor (e.g., a dual-core processor, triple-core processor, quad-core processor, etc.), microprocessor, etc. In some embodiments, the one or more processors may be external to the apparatus, for example the one or more processors may be a remote processor (e.g., a cloud-based processor). Alternatively or additionally, the one or more processors may be internal and/or local to the apparatus. In this regard, a given circuit or components thereof may be disposed locally (e.g., as part of a local server, a local computing system, etc.) or remotely (e.g., as part of a remote server such as a cloud-based server). To that end, a "circuit" as described herein may include components that are distributed across one or more locations.

Embodiments within the scope of the present disclosure include program products comprising machine-readable media for carrying or having machine-executable instructions or data structures stored thereon. Such machine-readable media can be any available media that can be accessed by a general purpose or special purpose computer or other machine with a processor. By way of example, such machine-readable media can comprise RAM, ROM, EPROM, EEPROM, or other optical disk storage, magnetic disk storage or other magnetic storage devices, or any other medium which can be used to carry or store desired program code in the form of machine-executable instructions or data structures, and which can be accessed by a general purpose or special purpose computer or other machine with a processor. Combinations of the above are also included within the scope of machine-readable media. Machine-executable instructions include, for example, instructions and data which cause a general-purpose computer, special purpose computer, or special purpose processing machines to perform a certain function or group of functions.

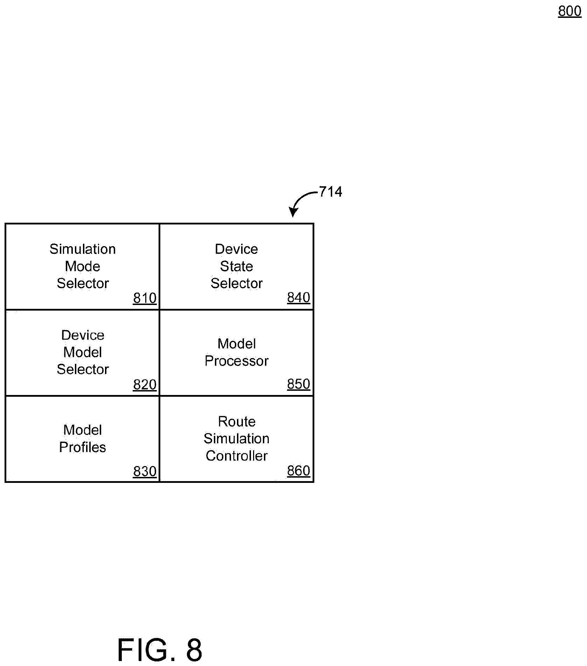

FIG. 8 depicts an example simulation control architecture, in accordance with present implementations. As illustrated by way of example in FIG. 8, an example simulation control architecture 800 can include at least a simulation mode selector 810, a device model selector 820, model profiles 830, a device state selector 840, a model processor 850, and a route simulation controller 860. The simulation control architecture 800 can, for example, correspond to a portion of non-volatile memory of the memory device 714, and can include one or more instructions configured to execute operation in accordance with one or more of the structures of the simulation control architecture 800 illustrated in FIG. 8, by way of example.

The simulation mode selector 810 can include one or more instructions to selectably operate the SCM 110 in a simulation mode or a live mode. For example, the simulation mode selector 810 can include instructions to select operation in a simulation mode or a live mode in response to an instruction received via the system HMI 132 or the mobile device 106 linked with the managed switch 130 to select the simulation mode or the live mode. For example, the simulation mode selector 810 can include instructions to select operation in a simulation mode or a live mode in response to an instruction received via the system HMI 132 or the mobile device 106 linked with the managed switch 130 to select the simulation mode or a live mode.

The device model selector 820 can include one or more instructions to select one or more models each corresponding to one or more devices coupled with the SCM 110. For example, the device model selector 820 can select one model corresponding to a single device coupled with the SCM 110 including the device model selector 820, or can select a plurality of models each corresponding to a corresponding one of a plurality of devices coupled with the SCM 110. The device model selector 820 can detect one or more of the devices coupled with the SCM 110 including the device model selector 820. For example, example, the device model selector 820 can detect a utility, switch, or genset based on an identifier or a power characteristic of the utility, switch, or genset transmitted by or detected from the utility, switch, or genset.

The device model selector 820 can select a model in response to an instruction received at the device model selector 820 indicating a model of one or more of the devices coupled with the SCM 110 including the device model selector 820. For example, the device model selector 820 can receive an instruction via the system HMI 132 or the mobile device 106 coupled with the managed switch 130 to select models corresponding to a utility and a switch coupled with the SCM 110, including the device model selector 820. The system HMI 132 or the mobile device 106 coupled with the managed switch 130 can, for example, transmit the instruction to a particular SCM 110 or a plurality of SCMs 110 based on a topology of the system corresponding to the SCMs 110. Thus, the system HMI 132 or the mobile device 106 coupled with the managed switch 130 can control or cause model selections by or at one or more particular SCMs 110 based on a topology of a microgrid system and corresponding to the specific system including the SCMs 110.

The model profiles 830 can include one or more input and output models corresponding to particular objects of the microgrid or compatible with the microgrid. For example, the model profiles 830 can define simulation profiles for any devices that can be coupled with a microgrid system, including, but not limited to, switches, gensets, utilities, loads, or any combination thereof. Each model can include a configuration based on a topology or an instruction received at the device model selector 820 based on a topology of the microgrid that includes the SCM 110. The device model selector 820 can instantiate one or more objects based on one or more model profiles 830, corresponding to the number and type of devices coupled with the particular SCM 110. For example, device model selector 820 can generate one instance of a genset have first power characteristics corresponding to a genset coupled with an SCM 110 having the device model selector 820. For example, device model selector 820 can generate two instances of a genset, with a first instance having first power characteristics corresponding to a first genset coupled with an SCM 110 having the device model selector 820, and a second instance having first power characteristics corresponding to a first genset coupled with an SCM 110 having the device model selector 820.

The device state selector 840 can include one or more instructions to selectably simulate one or more devices of the SCM 110 in a no-fault mode or a faulted mode. For example, the device state selector 840 can include instructions to select operation in a no-fault mode or a faulted mode in response to an instruction received via the system HMI 132 or the mobile device 106 linked with the managed switch 130 to select the simulation mode or the live mode. For example, the simulation mode selector 810 can include instructions to select operation in a no-fault simulation mode or faulted simulation mode in response to an instruction received via the system HMI 132 or the mobile device 106 linked with the managed switch 130 to select the no-fault simulation mode or faulted simulation mode.

The model processor 850 can include one or more instructions to execute one or more of the models of the devices coupled with the SCM 110 including the model processor 850. For example, the model processor 850 can include instructions to load particular models of the SCM 110 obtained by the device model selector 820 into the processor 712 for execution.

The route simulation controller 860 can include one or more instructions to execute one or more of the models of the devices coupled with the SCM 110 including the model processor 850, according to a topology of a microgrid system including the SCM 110. For example, the model processor 850 can include instructions to receive and transmit instructions corresponding to particular simulations output of particular SCMs 110, based on the devices coupled with the SCMs 110. For example, the SCM 110 of the simulation device architecture 700 can receive instructions from one or more of the external SCMs 702, where outputs of devices of the external SCMs 702 are configured to provide input to one or more devices of the SCM 110. For example, the SCM 110 of the simulation device architecture 700 can transmit instructions to one or more of the external SCMs 702, where inputs of devices of the external SCMs 702 are configured to receive output from one or more devices of the SCM 110.

For example, the computer readable medium can include one or more instructions executable by a processor. The processor can generate, via a model stored at the processor that corresponds to the electrical device, the first instruction to simulate the input to the electrical device. The processor can generate, via the model, the second instruction to simulate the output by the electrical device.

For example, the computer-readable medium can include one or more instructions executable by a processor. The processor can identify a selection of a first mode of simulation. The processor can generate, via the model in the first mode of simulation, the second instruction. The processor can identify a selection of a second mode of simulation. The processor can exclude, via the model in the second mode of simulation, the second instruction from transmission via the communication interface. The processor can receive, via the communication interface, a third instruction indicating a second input having a third electrical property to a second electrical device, the third instruction to simulate the second input to the second electrical device. The processor can generate, in response to receiving the third instruction at the controller device, a fourth instruction indicating a second output by the second electrical device, the second output having a fourth electrical property and responsive to the second input. The processor can transmit, via the communication interface, the fourth instruction to simulate the second output by the second electrical device.

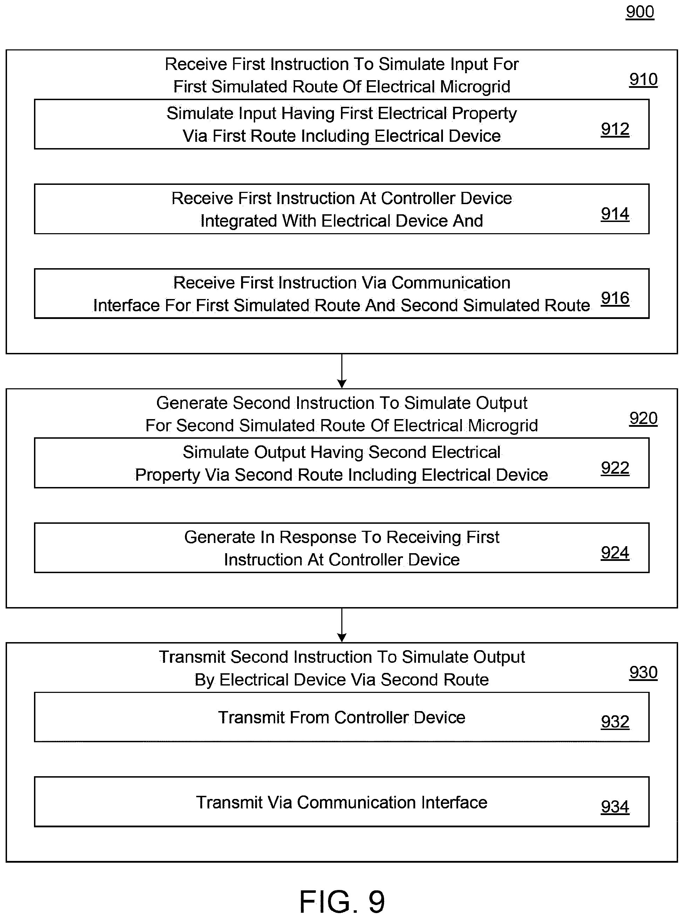

FIG. 9 depicts an example method of simulation of devices via routes of a microgrid network, in accordance with present implementations. At least an SMC 110 or the system 100 including a plurality of SCMs 110 coupled via the communication line 120 can perform method 900. For example, the method can correspond to simulating operation of one or more devices in an electrical microgrid by a communication interface corresponding to a first simulated route and a second simulated route of the electrical microgrid.

At 910, the method 900 can receive a first instruction to simulate an input for the first simulated route of an electrical microgrid. For example, the method 900 can include receiving, at a controller device via a communication interface, a first instruction to simulate an input via a first route, the controller device integrated with an electrical device, the input having a first electrical property, the first route including the electrical device and corresponding to a first simulated route of an electrical microgrid. For example, the method can include generating, by a model stored at the controller device that corresponds to the electrical device, the first instruction to simulate the input to the electrical device. For example, the method 900 can generate, by a processor via a communication interface, during simulation in a first mode and in response to receiving a first instruction to simulate an input via a first route, a second instruction to simulate an output via a second route, the communication interface corresponding to a first simulated route and a second simulated route of an electrical microgrid, the first instruction having a first electrical property, the first route corresponding to the first simulated route and including an electrical device coupled with the processor, the output having a second electrical property, the second route including the electrical device and corresponding to the second simulated route. At 912, the method 900 can simulate an input having a first electrical property via a first route including the electrical device. At 914, the method 900 can receive first instruction at a controller device integrated with an electrical device. At 916, the method 900 can receive first instruction via a communication interface for a first simulated route and a second simulated route.

At 920, the method 900 can generate a second instruction to simulate an output for the second simulated route of an electrical microgrid. For example, the method 900 can include generating, in response to receiving the first instruction at the controller device, a second instruction to simulate an output via a second route, the output having a second electrical property, the second route including the electrical device and corresponding to a second simulated route of the electrical microgrid. For example, the method 900 can include generating, by the model, the second instruction to simulate the output by the electrical device. For example, the method can include identifying, by the controller device, a selection of a first mode of simulation. For example, the method can include identifying, by the controller device, a selection of a second mode of simulation. For example, the method 900 can include generating, by the model in the first mode of simulation, the second instruction. For example, the method 900 can transmit, by the processor via the communication interface and during the simulation in the first mode, the second instruction to simulate the output by the electrical device via the second route. At 922, the method 900 can simulate an output having a second electrical property via a second route including the electrical device. At 924, the method 900 can generate a second instruction in response to receiving the first instruction at the controller device.

At 930, the method 900 can transmit the second instruction to simulate the output by the electrical device via the second route. For example, the method 900 can include transmitting, from the controller device via the communication interface, the second instruction to simulate the output by the electrical device via the second route. For example, the method 900 can include excluding, by one or more of the controller devices and the model in the second mode of simulation, the second instruction from transmission via the communication interface. At 932, the method 900 can transmit from the controller device. At 934, the method 900 can transmit via the communication interface.

For example, the method can include receiving, via the communication interface at the controller device, a third instruction indicating a second input having a third electrical property to a second electrical device, the third instruction to simulate the second input to the second electrical device. For example, the method can include generating, in response to receiving the third instruction at the controller device, a fourth instruction indicating a second output by the second electrical device, the second output having a fourth electrical property and responsive to the second input. For example, the method can include transmitting, from the controller device via the communication interface, the fourth instruction to simulate the second output by the second electrical device. For example, the method can include generating, by a second model stored at the controller device that corresponds to the second electrical device, the third instruction to simulate the input to the second electrical device. For example, the method 900 can include generating, by the model, the fourth instruction to simulate the second output by the second electrical device.

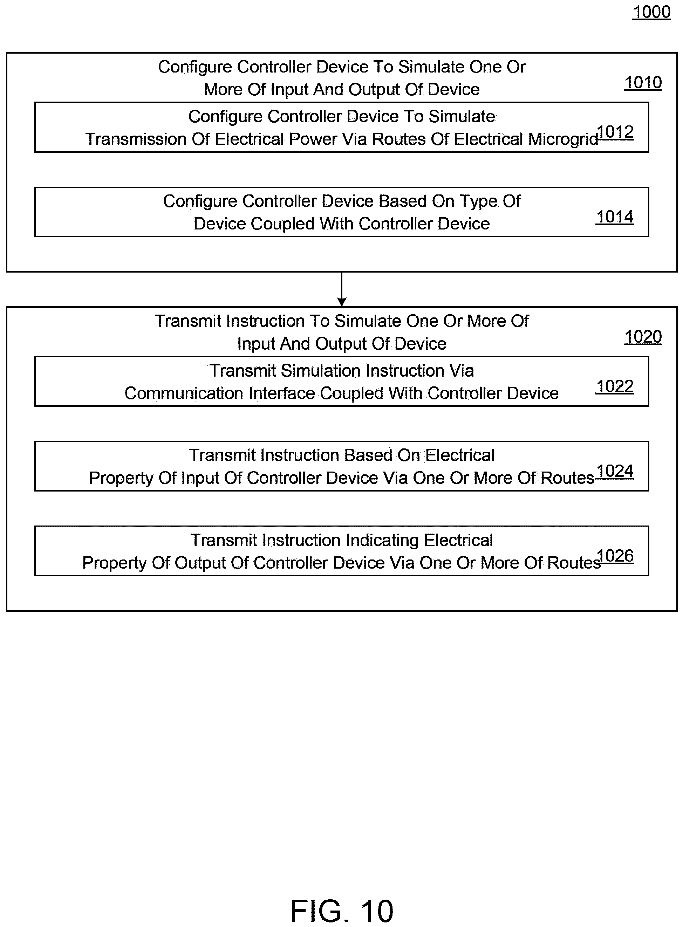

FIG. 10 depicts an example method of configuration and simulation of devices via routes of a microgrid network, in accordance with present implementations. At least an SMC 110 or the system 100 including aplurality of SCMs 110 coupled via the communication line 120 can perform method 1000.

At 1010, the method 1000 can configure the controller device to simulate one or more of input and output of the device. For example, the method 1000 can include configuring, based on a type of a device coupled with a controller device, the controller device to simulate one or more of input and output of the device, the device configured to transmit electrical power via one or more routes of an electrical microgrid. For example, the method can include configuring, based on a type of a second device coupled with the controller device, the controller device to simulate one or more of input and output of the second device, the second device configured to transmit electrical power via one or more of the routes of the electrical microgrid. At 1012, the method 1000 can configure the controller device to simulate transmission of electrical power via routes of an electrical microgrid. At 1014, the method 1000 can configure the controller device based on a type of a device coupled with a controller device.

For example, the method can include modifying, via the communication interface, a mode of operation of the device, the mode of operation indicating whether the controller device is configured to simulate one or more of the input and the output of the device via one or more of the routes of the electrical microgrid. For example, the method can include modifying, via the communication interface, a mode of simulation of the device, the mode of simulation indicating whether the controller device is configured to simulate the device in an active or inactive state.

At 1020, the method 1000 can transmit an instruction to simulate one or more of the input and the output of the device. For example, the method 1000 can include transmitting, via a communication interface coupled with the controller device, an instruction to simulate one or more of the input and the output of the device, the instruction indicating an electrical property of one or more of the input and the output of the device via one or more of the routes. For example, the method can include transmitting the instruction in response to a determination that the mode of operation indicates that the first controller device is configured to simulate one or more of the input and the output of the first device via one or more of the routes of the electrical microgrid. For example, the method can include transmitting the instruction in response to a determination that a mode of simulation of the controller device indicates that the controller device is configured to simulate the device in an active state. For example, the method 1000 can include excluding the instruction from transmission via the communication interface, in response to a determination that a mode of simulation of the controller device indicates that the controller device is configured to simulate the device in an inactive state. At 1022, the method 1000 can transmit a simulation instruction via a communication interface coupled with the controller device. At 1024, the method 1000 can transmit the instruction based on an electrical property of the input of the controller device via one or more of the routes of the electrical microgrid. At 1026, the method 1000 can transmit the instruction indicating an electrical property of the output of the controller device via one or more of the routes of the electrical microgrid.

For example, the method 1000 can exclude, by the processor via the communication interface and during simulation in a second mode, the second instruction from transmission via the communication interface. The processor can exclude, by the processor via the communication interface and during simulation in a second mode, the second instruction from transmission via the communication interface.

Having now described some illustrative implementations, the foregoing is illustrative and not limiting, having been presented by way of example. In particular, although many of the examples presented herein involve specific combinations of method acts or system elements, those acts and those elements may be combined in other was to accomplish the same objectives. Acts, elements, and features discussed in connection with one implementation are not intended to be excluded from a similar role in other implementations.

The phraseology and terminology used herein is for the purpose of description and should not be regarded as limiting. The use of "including," "comprising," "having," "containing," "involving," "characterized by," "characterized in that," and variations thereof herein, is meant to encompass the items listed thereafter, equivalents thereof, and additional items, as well as alternate implementations consisting of the items listed thereafter exclusively. In one implementation, the systems and methods described herein consist of one, each combination of more than one, or all of the described elements, acts, or components.

References to "or" may be construed as inclusive so that any terms described using "or" may indicate any of a single, more than one, and all of the described terms. References to at least one of a conjunctive list of terms may be construed as an inclusive OR to indicate any of a single, more than one, and all of the described terms. For example, a reference to "at least one of 'A' and 'B‴ can include only 'A', only 'B', as well as both "A' and 'B'. Such references used in conjunction with "comprising" or other open terminology can include additional items. References to "is" or "are" may be construed as nonlimiting to the implementation or action referenced in connection with that term. The terms "is" or "are" or any tense or derivative thereof, are interchangeable and synonymous with "can be" as used herein, unless stated otherwise herein.

Directional indicators depicted herein are example directions to facilitate understanding of the examples discussed herein, and are not limited to the directional indicators depicted herein. Any directional indicator depicted herein can be modified to the reverse direction, or can be modified to include both the depicted direction and a direction reverse to the depicted direction, unless stated otherwise herein. While operations are depicted in the drawings in a particular order, such operations are not required to be performed in the particular order shown or in sequential order, and all illustrated operations are not required to be performed. Actions described herein can be performed in a different order. Where technical features in the drawings, detailed description or any claim are followed by reference signs, the reference signs have been included to increase the intelligibility of the drawings, detailed description, and claims. Accordingly, neither the reference signs nor their absence has any limiting effect on the scope of any clam elements.

The scope of the systems and methods described herein is thus indicated by the appended claims, rather than the foregoing description. The scope of the claims includes equivalents to the meaning and scope of the appended claims.

## Claims

1. A method of simulating operation of one or more devices in an electrical microgrid by a communication interface corresponding to a first simulated route and a second simulated route of the electrical microgrid, the method comprising:
receiving, at a controller device via a communication interface, a first instruction to simulate an input via a first route, the controller device integrated with an electrical device, the input having a first electrical property, the first route including the electrical device and corresponding to a first simulated route of an electrical microgrid;
generating, in response to receiving the first instruction at the controller device, a second instruction to simulate an output via a second route, the output having a second electrical property, the second route including the electrical device and corresponding to a second simulated route of the electrical microgrid; and
transmitting, from the controller device via the communication interface, the second instruction to simulate the output by the electrical device via the second route.

2. The method of claim 1, further comprising:
generating, by a model stored at the controller device that corresponds to the electrical device, the first instruction to simulate the input to the electrical device; and
generating, by the model, the second instruction to simulate the output by the electrical device.

3. The method of claim 2, further comprising:
identifying, by the controller device, a selection of a first mode of simulation; and
generating, by the model in the first mode of simulation, the second instruction.

4. The method of claim 2, further comprising:
identifying, by the controller device, a selection of a second mode of simulation; and
excluding, by one or more of the controller devices and the model in the second mode of simulation, the second instruction from transmission via the communication interface.

5. The method of any of claims 1 to 4, further comprising:
receiving, via the communication interface at the controller device, a third instruction indicating a second input having a third electrical property to a second electrical device, the third instruction to simulate the second input to the second electrical device.

6. The method of claim 5, further comprising:
generating, in response to receiving the third instruction at the controller device, a fourth instruction indicating a second output by the second electrical device, the second output having a fourth electrical property and responsive to the second input.

7. The method of claim 6, further comprising:
transmitting, from the controller device via the communication interface, the fourth instruction to simulate the second output by the second electrical device.

8. The method of claim 5, further comprising:
generating, by a second model stored at the controller device that corresponds to the second electrical device, the third instruction to simulate the input to the second electrical device; and
generating, by the model, a fourth instruction to simulate the second output by the second electrical device.

9. The method of any of claims 1 to 8, further comprising configuring, based on a type of the electrical device, the controller device to perform the simulation of one or more of the input and the output of the device.

10. The method of any of claims 1 to 9, further comprising:
modifying, via the communication interface, a mode of operation of the electrical device.

11. The method of any of claims 1 to 10, further comprising:
modifying, via the communication interface, a mode of simulation of the electrical device, the mode of simulation indicating whether the controller device is configured to simulate the electrical device in an active or inactive state.

12. The method of any of claims 1 to 11, further comprising:
transmitting, in response to a determination that a mode of simulation of the controller device indicates that the controller device is configured to simulate the device in an active state, the instruction; and
excluding, in response to a determination that a mode of simulation of the controller device indicates that the controller device is configured to simulate the device in an inactive state, the instruction from transmission via the communication interface.

13. The method of any of claims 1 to 12, further comprising:
configuring, based on a type of a second device coupled with the controller device, the controller device to simulate one or more of input and output of the second device, the second device configured to transmit electrical power via one or more of the routes of the electrical microgrid.

14. A system, comprising:
one or more processors to execute the method of any of claims 1 to 13.

15. A non-transitory computer-readable medium comprising computer-executable instructions that when executed by one or more processors cause the one or more processors to perform the method of any of claims 1 to 13.
